# EUROPÄISCHE PATENTANMELDUNG

(11) **EP 3 905 528 A1**
(43) Veröffentlichungstag der Anmeldung: **03.11.2021**
(21) Anmeldenummer: 20172084.4
(22) Anmeldetag: 29.04.2020
(51) Int. Cl.: H03K 17/96, H03K 17/975

(54) **HANDGEFÜHRTE WERKZEUGMASCHINE**

(71) Anmelder: Hilti Aktiengesellschaft, 9494 Schaan (LI)
(72) Erfinder: Koschel, Christian, 86199 Augsburg (DE); Ruff, Christian, 86391 Stadtbergen (DE); Schwarz, Stefan, 86899 Landsberg (DE); Fürfanger, Georg, 81373 München (DE)
(74) Vertreter: Hilti Aktiengesellschaft Corporate Intellectual Property

(57) **Zusammenfassung**

Die Erfindung betrifft ein Verfahren zur Betätigung einer handgeführten Werkzeugmaschine (1) mit einer Antriebseinrichtung (4), wobei eine Steuerungseinrichtung (8) zur Betätigung der Antriebseinrichtung (4) und wenigstens zwei mit der Steuerungseinrichtung (8) wirkverbundene, kapazitive Sensorelemente (30, 31, 32, 33, 34, 35, 40) vorgesehen sind. Das Verfahren ist durch die folgenden Verfahrensschritte gekennzeichnet:
- Ermittlung einer elektrischen Ladung des ersten und zweiten Sensorelements (30, 31, 32, 33, 34, 35, 40),
- Vergleichen der ermittelten ersten elektrischen Ladung mit einem definierten ersten Schwellwert und der ermittelten zweiten elektrischen Ladung mit einem definierten zweiten Schwellwert;
- Freigabe der Betätigung der Antriebseinrichtung (4) und/oder definierte Ansteuerung der Antriebseinrichtung (4) durch die Steuerungseinrichtung (8), wenn eine vordefinierte Bedingung zwischen der ermittelten ersten elektrischen Ladung des ersten Sensorelements (30, 31, 32, 33, 34, 35, 40) und der ermittelten detektierten zweiten elektrischen Ladung des zweiten Sensorelements (30, 31, 32, 33, 34, 35, 40) vorliegt.

Es wird weiterhin eine Werkzeugmaschine (1) zur Durchführung eines derartigen Verfahrens beschrieben.

## Beschreibung

Die Erfindung betrifft ein Verfahren zur Betätigung einer handgeführten Werkzeugmaschine mit einer Antriebseinrichtung, mittels der ein mit der Werkzeugmaschine in Wirkverbindung bringbares Werkzeug betätigbar ist, wobei eine Steuerungseinrichtung zur Betätigung der Antriebseinrichtung und wenigstens zwei mit der Steuerungseinrichtung wirkverbundene, kapazitive Sensorelemente vorgesehen sind, gemäß der im Oberbegriff des Patentanspruches 1 definierten Art. Weiterhin betrifft die Erfindung eine handgeführte Werkzeugmaschine zur Durchführung eines derartigen Verfahrens gemäß der im Oberbegriff des Patentanspruches 6 definierten Art.

Aus der Praxis sind handgeführte Werkzeugmaschinen bekannt, die mit einem kapazitiven Sensor ausgeführt sind. Mittels des kapazitiven Sensors ist beispielsweise ein Leistungsschalter freigebbar und daraufhin über einen anwenderseitig betätigbaren Schalter eine Antriebseinrichtung betätigbar. Mittels des kapazitiven Sensors ist dabei eine sogenannte Totmann-Funktion bereitstellbar. Der kapazitive Sensor ist beispielsweise in einem Griffbereich der Werkzeugmaschine angeordnet und kann eine in dem Griffbereich befindliche Hand eines Anwenders detektieren.

Es ist weiterhin bekannt mehrere derartige, in verschiedenen Bereichen der Werkzeugmaschine angeordnete, kapazitive Sensoren vorzusehen, wobei eine Detektion eines Sensors eine anwenderseitige Betätigung eines Schalters einen Betrieb der Werkzeugmaschine freigibt.

Bei bekannten handgeführten Werkzeugmaschinen liegt somit ein relativ starres System vor.

Es ist daher Aufgabe der vorliegenden Erfindung, ein Verfahren zur Betätigung einer handgeführten Werkzeugmaschine und eine handgeführte Werkzeugmaschine mit wenigstens zwei kapazitiven Sensorelementen bereitzustellen, die eine größere Flexibilität in der Betätigung der Antriebseinrichtung ermöglichen.

Es wird somit Verfahren zur Betätigung einer handgeführten Werkzeugmaschine mit einer Antriebseinrichtung, mittels der ein mit der Werkzeugmaschine in Wirkverbindung bringbares Werkzeug betätigbar ist, vorgeschlagen, wobei eine Steuerungseinrichtung zur Betätigung der Antriebseinrichtung und wenigstens zwei mit der Steuerungseinrichtung wirkverbundene, kapazitive Sensorelemente vorgesehen sind.

Das Verfahren ist durch die folgenden Verfahrensschritte gekennzeichnet:
- Ermittlung einer ersten elektrischen Ladung des ersten Sensorelements,
- Ermittlung einer zweiten elektrischen Ladung des zweiten Sensorelements,
- Vergleichen der ermittelten ersten elektrischen Ladung mit einem definierten ersten Schwellwert;
- Vergleichen der ermittelten zweiten elektrischen Ladung mit einem definierten zweiten Schwellwert;
- Freigabe der Betätigung der Antriebseinrichtung und/oder definierte Ansteuerung der Antriebseinrichtung durch die Steuerungseinrichtung, wenn eine vordefinierte Bedingung zwischen der ermittelten ersten elektrischen Ladung des ersten Sensorelements und der ermittelten detektierten zweiten elektrischen Ladung des zweiten Sensorelements vorliegt.

Ein erfindungsgemäßes Verfahren zur Betätigung einer handgeführten Werkzeugmaschine weist eine große Flexibilität in der Betätigung der Antriebseinrichtung auf, da die jeweils ermittelten elektrischen Ladungen von den zwei Sensoreinrichtungen in Bezug zueinander gesetzt werden und eine Betätigung der Antriebseinrichtung nur bei Vorliegen einer vordefinierten Bedingung freigegeben und eine anwenderseitige Anforderung zu einer Aktivierung der Antriebseinrichtung führt. Alternativ oder zusätzlich hierzu kann in Abhängigkeit der jeweils ermittelten elektrischen Ladungen von den zwei Sensoreinrichtungen eine definierte Ansteuerung der Antriebseinrichtung eingestellt werden und somit beispielsweise ein für den erkannten Anwendungsfall optimierter Betriebsmodus der Antriebseinrichtung automatisch eingestellt werden.

Hierdurch kann beispielsweise auf eine aktuelle Haltung der Werkzeugmaschine durch einen Anwender reagiert werden.

Mittels des Sensorelements und der Steuereinrichtung ist eine Anwesenheit einer Hand eines Anwenders in einem Detektionsbereich des Sensorelements, beispielsweise in dem Griffbereich bzw. in einem Haltebereich, ermittelbar. Das Vorhandensein einer Hand wird beispielsweise dadurch detektiert, dass das Sensorelement bei einer Aufladung mit einer konstanten Spannung durch die Hand eine größere elektrische Ladung aufnehmen kann. Es kann beispielsweise vorgesehen sein, dass das Sensorelement abwechselnd aufgeladen und entladen wird und bei Überschreiten eines definierten Schwellwerts für die ermittelte elektrische Ladung das Vorhandensein einer Hand angenommen wird.

Bei der handgeführten Werkzeugmaschine kann es sich um sämtliche Arten von handgeführten Werkzeugmaschinen, wie beispielsweise Schleifmaschinen, beispielsweise Winkelschleifer, Sägemaschinen, wie Säbelsägen, Stichsägen, Kreissägen oder Kettensägen, Bohrmaschinen, Meisselhammer oder dergleichen handeln.

Bei einer vorteilhaften Ausführungsform eines Verfahrens nach der Erfindung kann es vorgesehen sein, dass die Steuerungseinrichtung eine Betätigung der Antriebseinrichtung freigibt, wenn die ermittelte erste elektrische Ladung des ersten Sensorelements größer als der erste definierte Schwellwert und die ermittelte zweite elektrische Ladung des zweiten Sensorelements größer als der zweite definierte Schwellwert ist. Hierdurch kann beispielsweise erreicht werden, dass der Anwender die Werkzeugmaschine in verschiedenen Bereichen halten muss, um einen Betrieb der Antriebseinrichtung zu ermöglichen. Es können somit gewünschte Griffposition vorgegeben werden, wodurch auf einfache Weise ein sicherer Betrieb der Werkzeugmaschine erzielbar ist. Dabei kann es vorgesehen sein, dass die Sensorelemente derart angeordnet sind, dass ein Anwender mit einer Hand verschiedene Bereiche der Werkzeugmaschine berühren muss. Beispielsweise kann vorgesehen sein, dass ein Bereich in einem oberen Bereich der Werkzeugmaschine und ein Bereich in einem unteren Bereich der Werkzeugmaschine angeordnet ist, so dass beispielsweise ein Bereich von einem Daumen und der andere Bereich von den restlichen Findern berührbar ist. Wenn die den Sensorelementen zugeordneten Bereiche verhältnismäßig weit voneinander entfernt sind, kann auch vorgesehen sein, dass ein Betrieb der Werkzeugmaschine nur ermöglicht ist, wenn der Anwender die Werkzeugmaschine mit zwei Händen in den Bereichen greift.

Besonders bevorzugt können in Abhängigkeit des aktuellen Vergleichs verschiedene Betriebsmodi der Antriebseinrichtung eingestellt werden, da beispielsweise bei einer als Winkelschleifer ausgeführten Werkzeugmaschine der Winkelschleifer bei der Verwendung von verschiedenen Werkzeugen, wie beispielsweise einer Schleifscheibe oder einer Trennscheibe, von einem Anwender in unterschiedlichen Bereichen gehalten wird. Hierdurch kann die Werkzeugmaschine in Abhängigkeit des ermittelten Werkzeugs in einem für das jeweilige Werkzeug optimierten Betriebsmodus betrieben werden. Beispielsweise kann die Antriebsdrehzahl der Antriebseinrichtung von der Steuerungseinrichtung hierbei unterschiedlich eingestellt werden.

Bei einer vorteilhaften Ausführungsform eines Verfahrens nach der Erfindung kann es vorgesehen sein, dass die Steuerungseinrichtung eine Betätigung der Antriebseinrichtung freigibt, wenn die ermittelte elektrische Ladung eines Sensorelements größer als der entsprechende definierte Schwellwert und die ermittelte elektrische Ladung des zweiten Sensorelements kleiner als der entsprechende definierte Schwellwert ist. Auf diese Weise ist eine Sicherheit beim Betrieb der Werkzeugmaschine erhöhbar. Dies kann beispielsweise dadurch erreicht werden, wenn das zweite Sensorelement in einem als Gefahrenbereich definierten Bereich der Werkzeugmaschine, beispielsweise in einem Nahbereich der Abtriebswelle und/oder des Werkzeugs angeordnet ist, und bei einer ermittelten Berührung in diesem Bereich ein Betrieb der Werkzeugmaschine unterbunden ist.

Insbesondere ist vorgesehen, dass fortlaufend die jeweils aktuelle elektrische Ladung der Sensorelemente mit dem jeweiligen Schwellwert verglichen wird und eine Änderung des Vergleichs zu einer Änderung der Betriebsbedingungen führt. Beispielsweise kann ein Überschreiten eines Schwellwertes eines einem Gefahrenbereich zugeordneten Sensorelements zu einem Ausschalten der Antriebseinrichtung führen.

Bei einer vorteilhaften Ausführungsform eines Verfahrens nach der Erfindung kann es vorgesehen sein, dass weitere Sensorelemente vorgesehen sind, wobei die elektrische Ladung des jeweiligen Sensorelements ermittelt wird und die ermittelte elektrische Ladung mit einem, dem jeweiligen Sensorelement zugeordneten definierten Schwellwert verglichen wird, wobei die Steuerungseinrichtung eine Betätigung der Antriebseinrichtung freigibt und/oder eine definierte Ansteuerung der Antriebseinrichtung vornimmt, wenn eine vordefinierte Bedingung zwischen den ermittelten Ladungen der jeweiligen Sensorelemente vorliegt. Je mehr Sensorelemente vorgesehen sind, desto flexibler und genauer können die jeweiligen Bedingungen definiert und auf die Haltung der Werkzeugmaschine durch den Anwender reagiert werden.

Zur Ermittlung der elektrischen Ladung eines Sensorelements werden bei einer vorteilhaften Ausführungsform eines Verfahrens nach der Erfindung folgende Schritte durchgeführt:
- Aufladung des jeweiligen Sensorelements insbesondere bis zu einer definierten Spannung
- Entladung des jeweiligen Sensorelements und Ermittlung einer elektrischen Ladung des jeweiligen Sensorelements mittels der Steuerungseinrichtung.

Die Steuerungseinrichtung ist hierbei zur Detektion von Ladungsänderungen des wenigstens einen Sensorelements ausgeführt, wobei beispielsweise das Vorhandensein einer Hand detektiert wird, wenn die ermittelte Ladung größer als ein definierter Schwellwert ist. Derartige Änderungen der ermittelten Ladung treten beispielsweise auf, wenn eine Hand eines Anwenders sich in einem definierten Bereich der Werkzeugmaschine befindet, da hierdurch eine Gesamtkapazität vergrößert wird. Die Steuerungseinrichtung gibt daraufhin vorzugsweise den Betrieb der Werkzeugmaschine bei einer anwenderseitigen Anforderung frei. Zur Ermittlung der tatsächlich vorhandenen elektrischen Ladung eines Sensorelements kann ein im Vergleich zu einer Kapazität des Sensorelements eine kleine Kapazität aufweisender Kondensator der Steuerungseinrichtung vorgesehen sein, der mit der elektrischen Ladung des Sensorelements jeweils vollständig aufgeladen und anschließend entladen wird und die Anzahl der Vorgänge gezählt werden, bis das betreffende Sensorelement komplett entladen ist. Wird ein definierter Schwellwert für die Anzahl dieser Vorgänge überschritten, kann dies als Vorhandensein einer Hand interpretiert werden.

Die Steuerungseinrichtung kann mit einem Steuerungselement ausgeführt sein, wobei das wenigstens eine Sensorelement mit dem Steuerungselement wirkverbunden ist. Das Steuerungselement ist insbesondere über Leitungen mit einem Hauptsteuergerät der Steuerungseinrichtung verbunden und kann hierdurch beabstandet zu dem Hauptsteuergerät angeordnet sein.

Die Aufgabe wird weiterhin mit einer handgeführten Werkzeugmaschine zur Durchführung eines derartigen Verfahrens mit einer Antriebseinrichtung gelöst, mittels der ein mit der Werkzeugmaschine in Wirkverbindung bringbares Werkzeug betätigbar ist, wobei eine Steuerungseinrichtung zur Betätigung der Antriebseinrichtung vorgesehen ist, wobei wenigstens zwei mit der Steuerungseinrichtung verbundene Sensorelemente vorgesehen sind.

Die im Zusammenhang mit dem Verfahren zur Betätigung einer handgeführten Werkzeugmaschine aufgeführten Vorteile gelten in analoger Weise auch für eine erfindungsgemäß ausgeführte handgeführte Werkzeugmaschine, die eine große Flexibilität in der Betätigung der Antriebseinrichtung ermöglicht.

Bei einer vorteilhaften Ausführungsform einer handgeführten Werkzeugmaschine nach der Erfindung können die Sensorelemente bzw. Detektionsbereiche der Sensorelemente in beliebigen Bereichen der Werkzeugmaschine angeordnet sein. Es kann beispielsweise vorgesehen sein, dass ein Sensorelement zumindest bereichsweise in einem Griffbereich der Werkzeugmaschine angeordnet ist. Weiterhin kann es vorgesehen sein, dass ein Sensorelement zumindest bereichsweise in einem Gefahrenbereich der Werkzeugmaschine, beispielsweise in einem Nahbereich einer Abtriebswelle oder eines Werkzeugs oder in einem Bereich, in der ein Halten der Werkzeugmaschine nicht erwünscht ist, angeordnet ist.

Die Steuerungseinrichtung kann mit einem Steuerungselement ausgeführt sein, wobei das wenigstens eine Sensorelement mit dem Steuerungselement wirkverbunden ist. Das Steuerungselement ist insbesondere über Leitungen mit einem Hauptsteuergerät der Steuerungseinrichtung verbunden und kann hierdurch beabstandet zu dem Hauptsteuergerät angeordnet sein.

Das wenigstens eine Sensorelement und die Steuerungseinrichtung, insbesondere das Steuerungselement, sind vorzugsweise Bestandteil eines kapazitiv messenden Sensors. Vorzugsweise ist das Steuerungselement als Leiterplatte ausgeführt und weist eine Kontrolleinheit und einen Signalerzeuger auf, wobei der Signalgeber insbesondere dazu ausgeführt ist, die beispielsweise als Leitungen ausgeführten Sensorelemente mit einer definierten Spannung aufzuladen. Die Kontrolleinheit ist vorzugsweise zur Detektion von Ladungsänderungen in dem wenigstens einen Sensorelement ausgeführt, wobei beispielsweise das Vorhandensein einer Hand detektiert wird, wenn die ermittelte Ladung größer als ein definierter Schwellwert ist. Derartige Änderungen der ermittelten Ladung treten beispielsweise auf, wenn eine Hand eines Anwenders sich in einem definierten Bereich der Werkzeugmaschine befindet, da hierdurch eine Gesamtkapazität vergrößert wird. Das Steuerungselement sendet daraufhin insbesondere ein Signal an die Steuerungseinrichtung, die daraufhin vorzugsweise den Betrieb der Werkzeugmaschine bei einer anwenderseitigen Anforderung freigibt. Zur Ermittlung der tatsächlich vorhandenen elektrischen Ladung eines Sensorelements kann ein im Vergleich zu einer Kapazität des Sensorelements eine kleine Kapazität aufweisender Kondensator vorgesehen sein, der mit der elektrischen Ladung des Sensorelements jeweils vollständig aufgeladen und anschließend entladen wird und die Anzahl der Vorgänge gezählt werden, bis das betreffende Sensorelement komplett entladen ist. Wird ein definierter Schwellwert für die Anzahl dieser Vorgänge überschritten, kann dies als Vorhandensein einer Hand interpretiert werden.

Bei einer vorteilhaften Ausführung einer erfindungsgemäßen Werkzeugmaschine kann ein mit der Steuerungseinrichtung wirkverbundener, anwenderseitig betätigbarer Leistungsschalter vorgesehen sein, wobei die Steuerungseinrichtung zur Überführung des Leistungsschalters zwischen einem inaktiven Zustand und einem aktiven Zustand ausgeführt ist, wobei eine anwenderseitige Betätigung des Leistungsschalters im aktiven Zustand des Leistungsschalters zu einer Betätigung der Antriebseinrichtung führt. Mittels der Steuerungseinrichtung ist der Leitungsschalter insbesondere somit derart betätigbar, dass eine anwenderseitige Betätigung eines mit dem Leistungsschalter wirkverbundenen Betätigungselements zur Kopplung der Antriebseinrichtung mit Strom, beispielsweise von einem Akkumulator oder aus einem Stromnetz, und hierdurch zur Betätigung der Antriebseinrichtung führt. Es kann auf einfache Weise erzielt werden, dass die Werkzeugmaschine erst betätigbar ist, wenn mittels der Steuerungseinrichtung in Zusammenwirkung mit dem wenigstens einen kapazitiven Sensorelement und/oder dem Steuerungselement eine beispielsweise im Griffbereich befindliche Hand detektierbar ist. Ebenso kann dabei vorgesehen sein, dass der sich im aktiven Zustand befindliche Leistungsschalter in den inaktiven Zustand überführt wird, wenn von der Steuerungseinrichtung in Zusammenwirkung mit dem wenigstens einen kapazitiven Sensorelement und/oder dem Steuerungselement keine sich mehr in dem Griffbereich befindliche Hand detektiert wird. Somit kann auf einfache Art und Weise eine sogenannte Totmannfunktion realisiert werden. Der Leistungsschalter ist im aktiven Zustand dazu ausgeführt einen Motorstrom zu der Antriebseinrichtung zu führen, wodurch das Werkzeug betätigbar ist.

Weitere Vorteile ergeben sich aus der folgenden Figurenbeschreibung. In den Figuren ist ein Ausführungsbeispiel der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine stark vereinfachte Längsschnittansicht einer als Winkelschleifer ausgeführten handgeführten Werkzeugmaschine, wobei an einer Abtriebswelle des Winkelschleifers ein Werkzeug angeordnet ist;
- Fig. 2: eine Längsschnittansicht des Winkelschleifers gemäß Fig. 1;
- Fig. 3: eine weitere Längsschnittansicht des Winkelschleifers gemäß Fig. 1 und Fig. 2;
- Fig. 4: eine Seitenansicht des Winkelschleifers gemäß Fig. 1 bis Fig. 3;
- Fig. 5: eine Querschnittsansicht des Winkelschleifers gemäß Fig. 1 bis Fig. 4 entlang der Linie A - A in Fig. 4;
- Fig. 6: eine vereinfachte Querschnittsansicht des Winkelschleifers gemäß Fig. 1 bis Fig. 5 entlang der Linie A - A in Fig. 5;
- Fig. 7: eine vereinfachte dreidimensionale Ansicht des Winkelschleifers gemäß Fig. 1 bis Fig. 6 ohne einen Teil eines Gehäuses, wobei ein Zusatzgriff gezeigt ist;
- Fig. 8: eine schematische Ansicht eines Wirkprinzips eines Sensorelements; und
- Fig. 9: eine vereinfachte dreidimensionale Ansicht eines Ausschnitts des Winkelschleifers gemäß Fig. 1 bis Fig. 8, wobei ein abgeschirmtes Sensorelement näher ersichtlich ist;
- Fig. 10: einen beispielhaften Ablauf eines Verfahrens zur Betätigung des Winkelschleifers gemäß Fig. 1 bis Fig. 9.

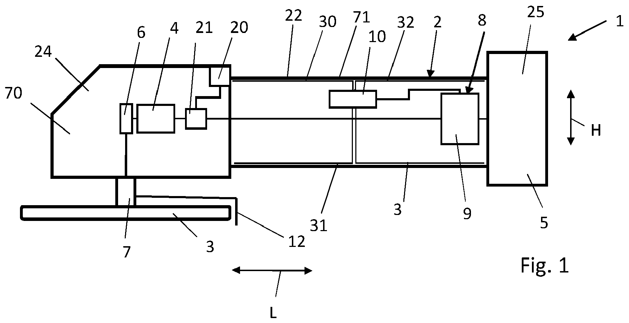

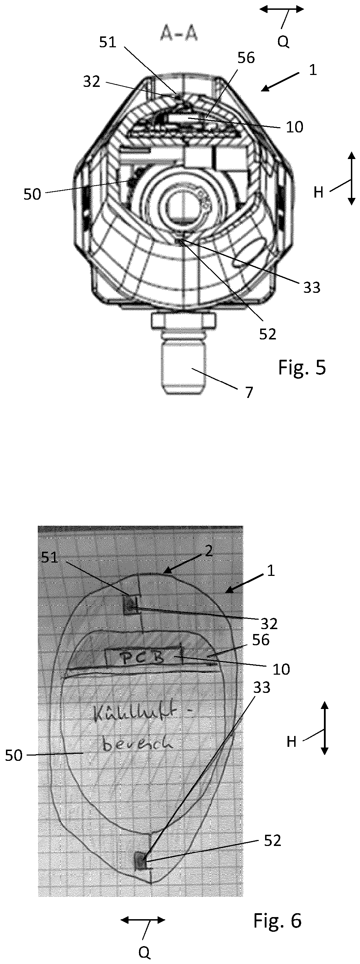

In Fig. 1 bis Fig. 7 und Fig. 9 ist eine handgeführte Werkzeugmaschine 1 nach der Erfindung gezeigt, die in der gezeigten Darstellung als Winkelschleifer ausgeführt ist. Entsprechend einer alternativen Ausgestaltungsform kann die Werkzeugmaschine 1 auch als Bohrmaschine, als Bohrhammer, als Sägemaschine, als Meisselhammer oder dergleichen ausgebildet sein.

Die in den Figuren als Winkelschleifer ausgeführte Werkzeugmaschine 1 weist ein Gehäuse 2 und ein beispielsweise als Trennscheibe oder Schleifscheibe ausgeführtes und lösbar einer Abtriebswelle 7 der Werkzeugmaschine 1 anbindbares Werkzeug 3 auf. Das Werkzeug 3 ist von einem insbesondere als Elektromotor ausgeführten Antrieb bzw. einer Antriebseinrichtung 4 betätigbar, der insbesondere über einen mit der Werkzeugmaschine 1 verbindbaren Akkumulator 5 mit Strom versorgbar ist. Der Akkumulator 5 ist ebenso wie das Gehäuse 2 nicht in sämtlichen Figuren gezeigt.

Gemäß einer alternativen und nicht in den Figuren gezeigte Ausgestaltungsform kann die Werkzeugmaschine 1 auch über ein Stromkabel mit elektrischem Strom aus einem Netzwerk versorgt werden.

Die Antriebseinrichtung 4 zur Betätigung des Werkzeugs 3 hier in einer drehenden Bewegung ist ebenso wie ein Getriebe 6 in einem Inneren des Gehäuses 2 angeordnet. Der beispielsweise als Elektromotor ausgeführte Antrieb 4, das Getriebe 6 und die Abtriebswelle 7, mit der das Werkzeug 3 wirkverbindbar ist, sind dabei derart zueinander angeordnet und miteinander verbunden, dass ein von dem Elektromotor 4 erzeugtes Drehmoment auf das Getriebe 6 und schließlich auf die Abtriebswelle 7 übertragen werden kann. Ein sich frei drehendes und hier nach unten an dem Gehäuse 2 herausragendes Ende der Abtriebswelle 7 ist mit dem hier als Trennscheibe 3 ausgeführten Werkzeug beispielsweise über eine nicht näher ersichtliche Spanneinrichtung verbunden. Das Drehmoment der Abtriebswelle 7 wird somit direkt auf die Trennscheibe 3 übertragen.

Es ist eine als Schutzhaube 12 ausgeführte Schutzeinrichtung vorgesehen, die vorzugsweise in herkömmlich bekannter Weise lösbar mit dem Gehäuse 2 der Werkzeugmaschine 1 verbindbar ist und zum Schutz eines Anwenders im Betrieb der Werkzeugmaschine 1 vorgesehen sein kann.

Das Gehäuse 2 weist wenigstens einen Haltebereich 22 bzw. Griffbereich auf, der zum Halten und Führen der Werkzeugmaschine 1 durch eine oder beide Hände eines Anwenders vorgesehen ist. Dem Haltebereich 22 ist ein Schalter 20 zugeordnet, der von einem Anwender betätigbar ist, wenn die Werkzeugmaschine 1 in dem Griffbereich 22 gehalten wird.

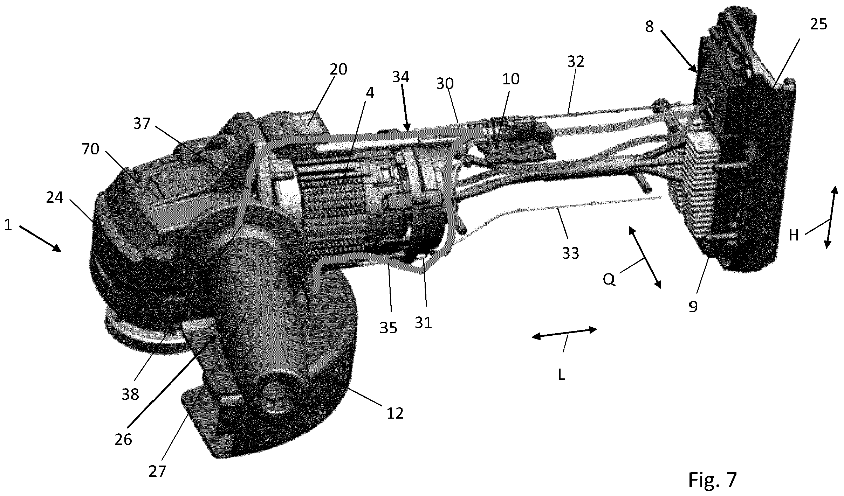

Alternativ oder zusätzlich hierzu kann die Werkzeugmaschine 1 eine weitere Griffeinrichtung 26 aufweisen, die beispielsweise in einem dem Werkzeug 3 zugewandten Kopfbereich 24 der Werkzeugmaschine 1 lösbar mit dem Gehäuse 2 der Werkzeugmaschine 1 in Wirkverbindung bringbar ist und beispielsweise eine andere Arbeitsposition für den Anwender zur Verfügung stellt. Fig. 7 zeigt einen derartigen Zusatzgriff 26, der im Bereich einer Anbindungsstelle 28 lösbar mit dem Gehäuse 2 verbindbar ist.

Die Werkzeugmaschine 1 weist weiterhin eine Steuerungseinrichtung 8 auf, die hier mit einer Hauptsteuerungselektronik 9 und einem Steuerungselement 10 ausgeführt ist. Das Steuerungselement 10 ist vorzugsweise als Leiterplatte ausgeführt und ist elektrisch und elektronisch mit der Hauptsteuerungselektronik 9, die vorliegend im Bereich des Akkumulators 5 angeordnet ist, verbunden.

Mit der Hauptsteuerungselektronik 9 ist wiederum ein anwenderseitig mittels des Schalters 20 betätigbarer Leistungsschalter 21 verbunden. Der beispielsweise als MOSFET ausgeführte Leistungsschalter 21 ist zur Freigabe eines Stroms von dem Akkumulator 5 zu dem Elektromotor 4 vorgesehen.

Die Werkzeugmaschine 1 ist vorliegend mit einer sogenannten Totmannfunktion ausgeführt. Hierzu ist der Leistungsschalter 21 von der Steuerungseinrichtung 8 zwischen einem aktiven Zustand, in dem eine anwenderseitige Betätigung des Schalters 20 zu einer Betätigung des Elektromotors 4 führt und einem inaktiven Zustand, in dem eine anwenderseitige Betätigung des Schalters 20 nicht zu einer Betätigung des Elektromotors führt, überführbar. Zur Überführung des Leistungsschalters 21 zwischen dem aktiven Zustand und dem inaktiven Zustand ist das Steuerungselement 10 in der im Folgenden näher erläuterten Weise ausgeführt.

Das Steuerungselement 10 ist vorliegend mit mehreren Sensorelementen 30, 31, 32, 33, 34, 35 wirkverbunden, von denen in Fig. 1 vier ersichtlich sind. Die Sensorelemente 30, 31, 32, 33, 34, 35 sind hier jeweils mit einer Leitung ausgeführt bzw. als Leitung ausgeführt. Die vorliegend nur über das Steuerungselement 10 miteinander zusammenwirkenden Sensorelemente 30, 31, 32, 33, 34, 35 sind hier im Wesentlichen vergleichbar ausgeführt, erstrecken sich allerdings ausgehend von dem Steuerungselement 10 in verschiedene Bereiche der Werkzeugmaschine 1.

Das Steuerungselement 10 weist insbesondere eine Kontrolleinheit und einen Signalerzeuger auf, wobei der Signalgeber insbesondere dazu ausgeführt ist, die mit Leitungen ausgeführten Sensorelemente 30, 31, 32, 33, 34, 35 mit einer definierten Spannung aufzuladen. Die Kontrolleinheit ist vorzugsweise zur Detektion von Ladungsänderungen in dem wenigstens einen Sensorelement ausgeführt, wobei beispielsweise das Vorhandensein einer Hand detektiert wird, wenn die ermittelte Ladung größer als ein definierter Schwellwert ist.

Im Folgenden werden zur näheren Beschreibung der Werkzeugmaschine 1 eine Hochrichtung H, eine Längsrichtung L und eine Querrichtung Q verwendet. Im vorliegenden Ausführungsbeispiel betrifft die Längsrichtung L eine Richtung zwischen dem Akkumulator 5 und dem Kopfbereich 2. Die Hochrichtung H entspricht hier im Wesentlichen einer Erstreckungsrichtung der Abtriebswelle 7 und die Querrichtung steht im Wesentlichen senkrecht zu der Längsrichtung L und der Hochrichtung H und stellt im Wesentlichen die Erstreckungsrichtung der Griffeinrichtung 26 dar.

Ein erstes Sensorelement 30 verläuft ausgehend von dem Steuerungselement 10 zunächst im Wesentlichen in Hochrichtung H nach oben und von einem oberflächennahen Bereich aus in Längsrichtung L in Richtung des Kopfbereichs 24 nach vorne. Das erste Sensorelement 30 ist in seinem im Wesentlichen in Längsrichtung L verlaufenden Bereich innerhalb des Gehäuses 2 in einem Nahbereich zur Oberfläche des Gehäuses 2 angeordnet und verläuft hierbei im Wesentlichen im Haltebereich 22. Das erste Sensorelement 30 erstreckt sich in Längsrichtung L im Wesentlichen bis in einen Bereich, in dem der Elektromotor 4 angeordnet ist.

Ein zweites Sensorelement 31 verläuft ausgehend von dem Steuerungselement 10 zunächst im Wesentlichen in Hochrichtung H nach unten und von einem oberflächennahen Bereich aus in Längsrichtung L in Richtung des Kopfbereichs 24 nach vorne. Das zweite Sensorelement 31 ist in seinem im Wesentlichen in Längsrichtung L verlaufenden Bereich innerhalb des Gehäuses 2 wiederum in einem Nahbereich zur Oberfläche des Gehäuses 2 angeordnet und verläuft hierbei im Wesentlichen im Haltebereich 22. Das zweite Sensorelement 31 erstreckt sich in Längsrichtung L im Wesentlichen bis in einen Bereich, in dem der Elektromotor 4 angeordnet ist.

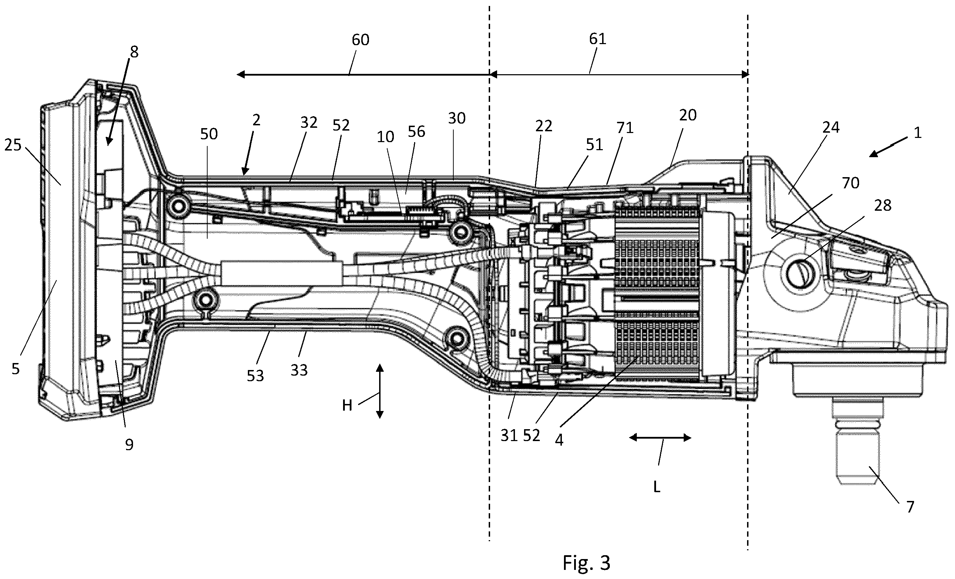

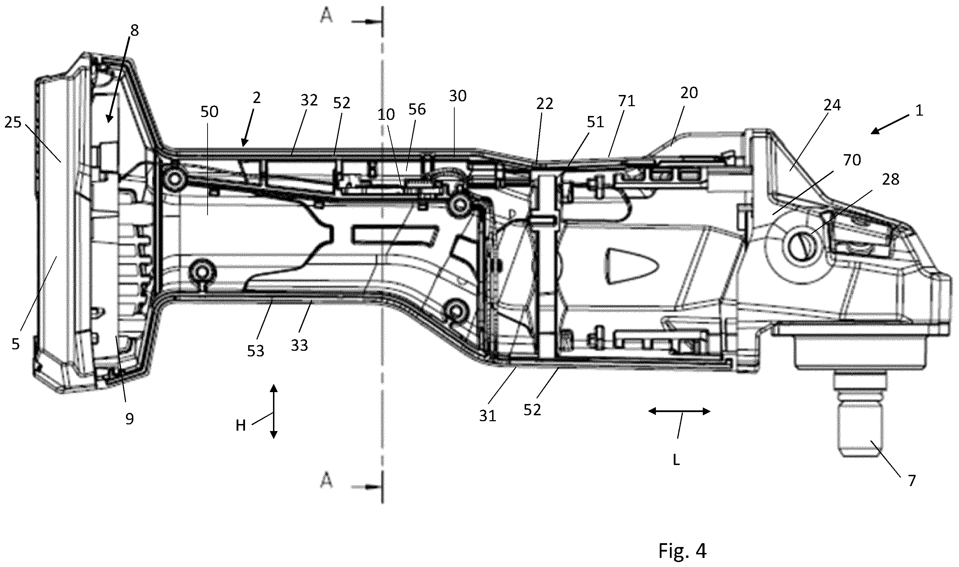

Ein drittes Sensorelement 32 verläuft ausgehend von dem Steuerungselement 10 zunächst im Wesentlichen in Hochrichtung H nach oben und von einem oberflächennahen Bereich aus in Längsrichtung L in Richtung des Fußbereichs 25 nach hinten. Das dritte Sensorelement 32 ist in seinem im Wesentlichen in Längsrichtung L verlaufenden Bereich innerhalb des Gehäuses 2 in einem Nahbereich zur Oberfläche des Gehäuses 2 angeordnet und verläuft hierbei im Wesentlichen im Haltebereich 22. Das dritte Sensorelement 32 erstreckt sich in Längsrichtung L im Wesentlichen bis in einen Bereich, in dem der Akkumulator 5 angeordnet ist. Das dritte Sensorelement 32 kann sich auch, wie in Fig. 3 und Fig. 4 ersichtlich ist, bis in einen Fußbereich 25 der Werkzeugmaschine 1, in der der Akkumulator 5 angeordnet ist, erstrecken.

Ein viertes Sensorelement 32 verläuft ausgehend von dem Steuerungselement 10 zunächst im Wesentlichen in Hochrichtung H nach unten und von einem oberflächennahen Bereich aus in Längsrichtung L in Richtung des Fußbereichs 25 nach hinten. Das vierte Sensorelement 33 ist in seinem im Wesentlichen in Längsrichtung L verlaufenden Bereich innerhalb des Gehäuses 2 in einem Nahbereich zur Oberfläche des Gehäuses 2 angeordnet und verläuft hierbei im Wesentlichen im Haltebereich 22. Das vierte Sensorelement 32 erstreckt sich in Längsrichtung L im Wesentlichen bis in einen Bereich, in dem der Akkumulator 5 angeordnet ist. Das vierte Sensorelement 33 kann sich auch, wie in Fig. 3 und Fig. 4 ersichtlich ist, bis in den Fußbereich 25 der Werkzeugmaschine 1 erstrecken.

Das erste Sensorelement 30 und das dritte Sensorelement 32 sind somit in einem bezüglich der Hochrichtung H oberen Bereich des Gehäuses 2 und das zweite Sensorelement 31 und das vierte Sensorelement 33 in einem bezüglich der Hochrichtung H unteren Bereich des Gehäuses 2 angeordnet.

In Fig. 7 sind stark vereinfacht ein fünften Sensorelement 34 und ein sechstes Sensorelement 35 gezeigt, wobei diese ebenfalls, vergleichbar zu den Sensorelementen 30, 31, 32, 33 mit dem Steuerungselement 10 verbunden sind. Das fünfte Sensorelement 35 erstreckt sich von dem Steuerungselement 10 bis zu der Griffeinrichtung 26 und insbesondere innerhalb der Griffeinrichtung 26 weiter bis in einem Griffbereich 27 der Griffeinrichtung 26. Hierbei kann vorgesehen sein, dass das fünfte Sensorelement 34 zweiteilig ausgeführt ist, mit einem ersten Teil 37, der innerhalb des Gehäuses 2 verläuft und einem zweiten Teil 38, der innerhalb der Griffeinrichtung 26 verläuft. Eine Anbindungseinrichtung 28 zur Anbindung der Griffeinrichtung 26 an dem Gehäuse 2 ist dabei derart ausgeführt, dass bei an dem Gehäuse 2 angebundener Griffeinrichtung 26 der erste Teil 37 des fünften Sensorelements 34 mit dem zweiten Teil 38 des fünften Sensorelements 34 wirkverbunden ist.

Das in Fig. 7 ebenfalls ersichtliche sechste Sensorelement 35 erstreckt sich von dem Steuerungselement 10 bis zu der Schutzeinrichtung 12, wobei ein Verlauf des sechsten Sensorelements 35 innerhalb des Gehäuses 2 grundsätzlich beliebig je nach vorliegenden Bauraumbedingungen wählbar ist. Mittels des sechsten Sensorelements 35 ist vorzugsweise ermittelbar, ob die Schutzeinrichtung 12 an dem Gehäuse 2 angebunden ist und insbesondere, ob die Schutzeinrichtung 12 in vorgesehener Weise, also korrekt, an dem Gehäuse 2 angebunden ist.

Bei einer alternativen Ausführung kann es auch vorgesehen sein, dass nur eine beliebige Kombination der Sensorelemente 30, 31, 32, 33, 34, 35 vorgesehen ist. Alternativ hierzu können auch weitere Sensorelemente vorgesehen sein, wobei beispielsweise auch Sensorelemente in einem bezüglich der Querrichtung Q seitlichen Bereich des Gehäuses 2 angeordnet sein können.

Die Sensorelemente 30, 31, 32, 33, 34, 35 sind vorliegend alle als kapazitive Sensorelemente ausgeführt, wobei im Zusammenspiel mit dem Steuerungselement 10 eine Ladungsänderung in dem jeweiligen Sensorelement 30, 31, 32, 33, 34, 35 ermittelbar ist. Zur Ermittlung einer Ladungsänderung kann vorgesehen sein, dass das jeweilige Sensorelement 30, 31, 32, 33, 34, 35 von der Steuerungseinrichtung 8 bzw. dem Steuerungselement 10 bis zu einer definierten Spannung aufgeladen wird und das jeweilige Sensorelement 30, 31, 32, 33, 34, 35 anschließend entladen wird. Hierbei kann es vorgesehen sein, dass beispielsweise dem Steuerungselement 10 ein Kondensator zugeordnet ist, der eine vergleichbar zu der typischen Aufladung eines Sensorelements 30, 31, 32, 33, 34, 35 kleine Kapazität aufweist und ermittelt wird, wie oft dieser von dem jeweiligen Sensorelement 30, 31, 32, 33, 34, 35 aufgeladen werden kann, bis das jeweilige Sensorelement 30, 31, 32, 33, 34, 35 vollständig entladen ist.

Die Ladung, die das jeweilige Sensorelement 30, 31, 32, 33, 34, 35 aufnehmen kann ist im Wesentlichen konstant. Eine menschliche Hand weist eine Kapazität auf, die sich zu der Kapazität des Sensorelements 30, 31, 32, 33, 34, 35 addiert, wenn die menschliche Hand in den Nahbereich des jeweiligen Sensorelements 30, 31, 32, 33, 34, 35 kommt. Da das jeweilige Sensorelement 30, 31, 32, 33, 34, 35 jeweils bis zu einer konstanten Spannung aufgeladen wird, steigt die von dem Sensorelement 30, 31, 32, 33, 34, 35 aufgenommene Ladung beispielsweise bei dem Vorhandensein einer Hand, so dass bei einem Entladen des jeweiligen Sensorelements 30, 31, 32, 33, 34, 35 eine größere Ladungsmenge als bei einem Zustand ohne der menschlichen Hand vorliegt.

Insbesondere die Sensorelemente 34 und 35 können derart ausgeführt sein, dass der jeweils zugeordnete definierte Schwellwert überschritten wird, wenn die Griffeinrichtung 26 bzw. die Schutzeinrichtung 12 in gewünschter Weise an dem Gehäuse 2 angeordnet ist und der jeweilige definierte Schwellwert beispielsweise nicht überschritten wird, wenn keine Griffeinrichtung 26 bzw. keine Schutzeinrichtung 12 montiert oder diese nicht in gewünschter Weise an dem Gehäuse 2 montiert ist.

Jedem Sensorelement 30, 31, 32, 33, 34, 35 ist ein definierter Schwellwert für die ermittelte elektrische Ladung zugeordnet, wobei das Überschreiten des jeweiligen Schwellwerts als Vorhandensein einer Hand bzw. als Vorhandensein der Griffeinrichtung 26 oder der Schutzeinrichtung 12 interpretiert wird.

Es vorgesehen sein, dass das Steuerungselement 10 den Leistungsschalter 21 von dem inaktiven Zustand in den aktiven Zustand überführt, wenn wenigstens eine ermittelte elektrische Ladung eines Sensorelements 30, 31, 32, 33, 34, 35 oder mehrere ermittelte elektrische Ladungen von verschiedenen Sensorelementen 30, 31, 32, 33, 34, 35 den jeweils zugeordneten Schwellwert überschreitet. Somit kann eine Voraussetzung zur Überführung des Leistungsschalters 21 von dem inaktiven Zustand in den aktiven Zustand sein, dass die von dem fünften Sensorelement 34 ermittelte Ladung den entsprechenden Schwellwert überschreitet und/oder die von dem sechsten Sensorelement 36 ermittelte Ladung den entsprechenden Schwellwert überschreitet und somit das Vorhandensein der Griffeinrichtung 26 und/oder der Schutzeinrichtung 12 zur Aktivierung des Leistungsschalters 21 erforderlich ist.

Eine tatsächliche Überführung des Leistungsschalters 21 von dem inaktiven Zustand in den aktiven Zustand erfolgt beispielsweise nur, wenn zusätzlich zu der oben genannten Voraussetzung eine vordefinierte Bedingung bei den Sensorelementen 30, 31, 32, 33 vorliegt und beispielsweise die ermittelte elektrische Ladung eines oder mehrere dieser Sensorelemente 30, 31, 32, 33 den jeweils zugeordneten definierten Schwellwert überschreitet.

Hierbei kann beispielsweise ermittelt werden, ob die Werkzeugmaschine 1 in gewünschter Weise von einem Anwender gehalten wird. Dies kann dadurch ermittelt werden, dass die ermittelten Ladungen von definierten Sensorelementen, die in entsprechenden Bereichen der Werkzeugmaschine 1 angeordnet sind, den jeweils zugeordneten Schwellwert überschreiten und/oder die ermittelten Ladungen von anderen definierten Sensorelementen, die in entsprechenden Bereichen der Werkzeugmaschine 1 angeordnet sind, den jeweils zugeordneten Schwellwert nicht überschreiten. Somit kann beispielsweise ermittelt werden, ob die Werkzeugmaschine in dem Haltebereich 22 und in dem Griffbereich 27 gehalten wird und der Leistungsschalter 21 beispielsweise nur in diesem Fall in den aktiven Zustand überführt wird.

Alternativ oder zusätzlich hierzu kann es vorgesehen sein, dass der Leistungsschalter 21 nicht in den aktiven Zustand überführt wird, wenn eine ermittelte Ladung eines definierten Sensorelements, das beispielsweise in einem bestimmten Bereich, beispielsweise in einem in einem Nahbereich des Werkzeugs 3 befindlichen Bereich, angeordnet ist, den zugeordneten Schwellwert überschreitet.

Zudem können durch entsprechende Positionierung der Sensorelemente 30, 31, 32, 33, 34, 35 verschiedene Griffpositionen eines Anwenders in Abhängigkeit von den ermittelten Ladungen der jeweiligen Sensorelemente 30, 31, 32, 33, 34, 35 ermittelt werden und die Antriebseinrichtung 4 in Abhängigkeit der ermittelten Griffposition in unterschiedlichen Betriebsmodi betrieben werden. Dies kann beispielsweise bei einer als Winkelschleifer ausgeführten Werkzeugmaschine 1 bei der Verwendung eines als Trennscheibe bzw. als Schleifscheibe ausgeführten Werkzeugs 3 vorgesehen sein, bei denen die Werkzeugmaschine 1 unterschiedlich gehalten wird und die Verwendung der verschiedenen Werkzeuge 3 eine voneinander unterschiedliche optimale Drehzahl aufweisen.

Alternativ oder zusätzlich hierzu kann es auch vorgesehen sein, dass der Leistungsschalter 21 nur dann von dem inaktiven Zustand in den aktiven Zustand überführt wird, wenn die von einem Sensorelement 30, 31, 32, 33, 34, 35 ermittelte elektrische Ladung kleiner als der jeweilige definierte Schwellwert ist. Dies kann insbesondere dafür vorgesehen sein, um zu verhindern, dass sich beispielsweise eine Hand eines Anwenders in einem definierten Bereich der Werkzeugmaschine 1 befindet. Als definierter Bereich kann beispielsweise ein Bereich vorgesehen sein, in dem ein Anwender keine Hand zum Betrieb der Werkzeugmaschine 1 haben darf. Alternativ oder zusätzlich hierzu kann der definierte Bereich ein Gefahrenbereich sein, der sich insbesondere im Nahbereich des Werkzeugs 3 befindet. Die entsprechenden Sensorelemente 30, 31, 32, 33, 34, 35 sind neben der gezeigten Ausführung in den gewünschten Bereichen der Werkzeugmaschine 1 anordenbar.

Ebenso kann es vorgesehen sein, dass der Leistungsschalter 21 von dem aktiven Zustand zurück in den inaktiven Zustand überführt wird, wenn die von einem Sensorelement 30, 31, 32, 33, 34, 35 ermittelte elektrische Ladung unter den jeweils definierten Schwellwert sinkt, da dies beispielsweise auf ein Entfernen einer Hand aus dem Haltebereich 22 bzw. dem Griffbereich 27 oder auf ein Entfernen der Schutzeinrichtung 12 und/oder der Griffeinrichtung 12 und somit einen unerwünschten Betriebszustand zurückzuführen ist.

Das fünfte Sensorelement 34 kann dafür vorgesehen sein, lediglich das Vorhandensein der Griffeinrichtung 26 zu ermitteln. Alternativ oder zusätzlich hierzu kann es auch vorgesehen sein, dass mittels des fünften Sensorelements 34 auch das Vorhandensein einer Hand eines Anwenders in dem Griffbereich 27 ermittelbar ist.

Um sicher zu verhindern, dass beispielsweise eine Hand, die sich in einem von dem vorgesehenen Detektionsbereich abweichenden Bereich befindet, beispielsweise in einem Bereich außerhalb des Griffbereichs 27, zu einem unerwünschten Überschreiten des zugeordneten definierten Schwellwerts führt, kann es vorgesehen sein, dass der von dem Detektionsbereich abgewandter Bereich des fünften Sensorelements 35 abgeschirmt ist und beispielsweise das Vorhandensein einer Hand eines Anwenders in diesem Bereich nicht zu einem Überschreiten des zugeordneten definierten Schwellwertes des fünften Sensorelements 34 führt.

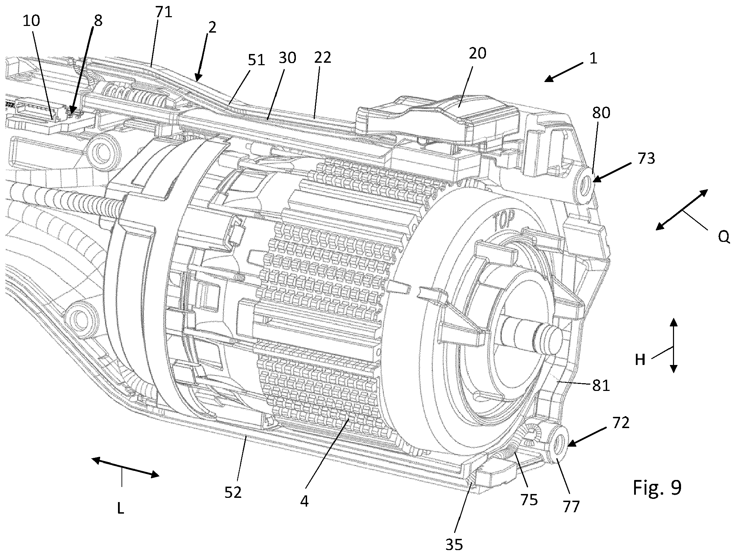

In Fig. 9 ist ein Ausschnitt der handgeführten Werkzeugmaschine 1 bzw. des Winkelschleifers näher ersichtlich, wobei der zumindest teilweise, insbesondere vollständig mit einem metallischen Gehäuse 70 ausgeführte Kopfbereich 24 des Winkelschleifers 1 nicht dargestellt ist. Es ist ein heckseitiger Teil 71 des Gehäuses 2 ersichtlich, der mehrere Anbindungsstellen 72, 73 zur Verbindung des heckseitigen Teils 71 des Gehäuses 2 mit dem metallischen Gehäuse 70 aufweist, von denen vorliegend zwei ersichtlich sind.

Um das fünfte Sensorelement 34 in nicht zur Detektion vorgesehenen Bereichen, beispielsweise in dem im heckseitigen Gehäuse 71 verlaufenden Bereich, vor Störungen, ungewünschten Detektionen bzw. Fehldetektionen beispielsweise durch die Antriebseinrichtung 4 zu schützen, ist der im Bereich des heckseitigen Gehäuses 71 verlaufende Teil des fünften Sensorelements 34 vorliegend von einem weiteren Element 75 umfasst. Das weitere Element 75 ist hier als Leitung 75 ausgeführt, die die Leitung des fünften Sensorelements 34 vorliegend spiralförmig umfasst bzw. einfasst.

Die Leitung 75 ist vorliegend zur Erdung mit einem Minuspol des Akkumulators 5 verbunden. Alternativ hierzu kann es auch vorgesehen sein, dass die Leitung 75 mit einem weiteren Sensoreingang verbunden ist.

Bei netzbetriebenen Werkzeugmaschinen kann die Leitung zur Erdung mit einem neutralen, geerdeten Leiter verbunden sein. Wenn ein Wechselstrom-Gleichstrom-Wandler vorgesehen ist, kann die Leitung 75 zur Erdung auch mit dem Minuspol des Gleichstromkreises verbunden sein.

Das fünfte Sensorelement 34, welches zur Reduzierung von parasitischen Kapazitätseffekten möglichst dünn ausgeführt ist, ist im Bereich der Anbindungsstelle 72 mit einem elektrisch leitenden Element 77 verbunden, welches bei einer Anbindung des heckseitigen Gehäuseteils 71 an das metallische Gehäuse 70 leitend mit einem weiteren Bereich des fünften Sensorelements 34 verbunden ist, der sich insbesondere bis in den Griffbereich 27 der Griffeinrichtung 26 erstreckt.

Mittels der das fünfte Sensorelement 34 in dem heckseitigen Gehäuseteil 71 ausgehend von dem Steuerungselement 10 bis zu der Anbindungsstelle 72 insbesondere nahezu vollständig umfassenden Leitung 75 sind ungewünschte Detektionen durch das fünfte Sensorelement 34 im Bereich des heckseitigen Gehäuseteils 71 sicher verhindert. Durch eine entsprechende Anordnung der Leitung 75 kann auch nur ein ausgewählter Bereich des Sensorelements 34 oder auch mehrere Bereiche des Sensorelements 34 in gewünschtem Umfang abgeschirmt werden und die Gefahr einer unerwünschten Detektion in diesem Bereich bzw. in diesen Bereichen sicher verhindert werden. Zur Detektion vorgesehene Bereich des Sensorelements 34 können somit sehr genau festgelegt werden.

Um den in dem metallischen Gehäuse 70 verlaufenden Bereich des fünften Sensorelements 34 ebenfalls sicher abzuschirmen und eine unerwünschte Detektion in diesem Bereich zu verhindern, ist das metallische Gehäuse 70 vorliegend geerdet und analog zu der Leitung 75 mit dem Minuspol des Akkumulators 5 verbunden. Hierzu ist vorliegend im Bereich der Anbindungsstelle 73 ein metallisches Element 80 bzw. ein metallischer Kontakt vorgesehen, welcher im Bereich des heckseitigen Gehäuseteils 71 über ein Verbindungselement 81 mit dem Minuspol des Akkumulators 5 verbunden ist. Hierdurch kann zuverlässig verhindert werden, dass eine Berührung des metallischen Gehäuses 70 zu einer Detektion des fünften Sensorelements 34 führt.

Entsprechend können die Sensorelemente 30, 31, 32, 33, 34, 35 zur Verhinderung einer ungewünschten Detektion in ausgewählten Bereichen in diesen Bereichen abgeschirmt sein, wobei hierzu ein oder mehrere geerdetes weiteres Element, beispielsweise eine geerdete Leitung oder ein geerdetes Gehäuseteil vorgesehen sein können.

In einem Bereich 61 der Werkzeugmaschine 1, in der der Elektromotor 4 angeordnet ist, liegen beispielsweise größere Störungen für die Sensorelemente 30, 31, 32, 33, 34, 35 vor, als in einem weiter von dem Elektromotor 4 entfernten Bereich 60. Um ein durch derartige Störungen verursachten Überschreiten des jeweiligen definierten Schwellwerts des jeweiligen Sensorelements 30, 31, 32, 33, 34, 35 zu verhindern, kann es vorgesehen sein, dass die definierten Schwellwerte der einzelnen Sensorelemente 30, 31, 32, 33, 34, 35 sich voneinander unterscheiden, wobei insbesondere diejenigen definierten Schwellwerte von im Bereich der Antriebseinrichtung 4 angeordneten Sensorelemente 30, 31, 34, 35 größer als die definierten Schwellwerte in von der Antriebseinrichtung 4 abgewandten der Sensorelemente 32, 33 sind.

Beispielsweise kann es vorgesehen sein, dass sich der jeweilige definierte Schwellwert aus der Summe eines für alle Sensorelemente 30, 31, 32, 33, 34, 35 im Wesentlichen identischen Berührungswertes und einem von den jeweiligen Umgebungsbedingungen abhängigen Grundsignalwertes zusammensetzt. Der Grundsignalwert ist dabei insbesondere umso höher, je größer die Störungen im Bereich des jeweiligen Sensorelements 30, 31, 32, 33, 34, 35 sind.

Es kann hierbei vorgesehen sein, dass insbesondere die definierten Schwellwerte der Sensorelemente 30, 31, 34, 35, die in der Antriebseinrichtung 4 zugewandten Bereichen angeordnet sind, in Abhängigkeit der definierten Schwellwerte der Sensorelemente 32, 33, die in von der Antriebseinrichtung 4 entfernten Bereichen angeordnet sind, eingestellt bzw. kalibriert werden. Die Einstellung bzw. Kalibrierung der definierten Schwellwerte der Sensorelemente 32, 33 kann dabei in definierten Zeitabständen oder kontinuierlich im Betrieb der Werkzeugmaschine 1 in Abhängigkeit eines oder mehrere der definierten Schwellwerte eines oder mehrere der Sensorelemente 30, 31, 34, 35 erfolgen.

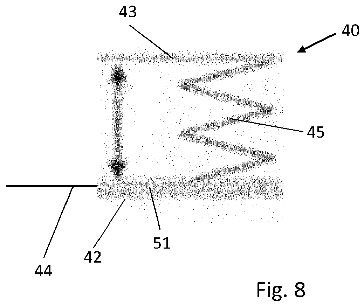

Fig. 8 zeigt exemplarisch einen Ausschnitt eines dem Steuerungselement 10 abgewandten Endbereichs 41 eines Sensorelements 40, das grundsätzlich vergleichbar zu den Sensorelementen 30, 31, 32, 33, 34, 35 ausgeführt ist und alternativ oder zusätzlich zu einem oder mehrerer der Sensorelemente 30, 31, 32, 33, 34, 35 eingesetzt werden kann. Der Endbereich 41 des Sensorelements 40 weist hier zwei plattenförmige Elemente 42, 43 auf, wobei ein erstes Element 42 beabstandet und verlagerbar gegenüber dem zweiten Element 43 angeordnet ist.

Das erste Element 42 stellt beispielsweise eine Grundplatte dar, die elektrisch und elektronisch mit einer Leitung 44 des Sensorelements 40 verbunden ist, die wiederum zur Kopplung an das Steuerungselement 10 vorgesehen ist. Das erste Element 42 und das zweite Element 43 können wie in Fig. 8 gezeigt plan ausgeführt sein. Bei einer alternativen Ausführung kann es auch vorgesehen sein, dass die Elemente 42 und 43 andersartig ausgeführt sind und beispielsweise gebogen sein, so dass das Sensorelement 40 auf einfache Weise beispielsweise auch im Griffbereich 27 angeordnet sein kann. Das Sensorelement 40 kann den Griffbereich 27 beispielsweise umfangsseitig teilweise oder nahezu vollständig umfassen, so dass mittels des Sensorelements 40 eine definierte Griffstärke im Griffbereich 27 ermittelbar ist.

Das erste Element 42 und das zweite Element 43 sind vorliegend über eine Federeinrichtung 45 miteinander verbunden, welche das zweite Element 43 in eine von dem ersten Element 42 beabstandete Position mit Kraft beaufschlagt.

Alternativ oder zusätzlich hierzu kann zwischen dem ersten Element 42 und dem zweiten Element 43 ein insbesondere elastisch verformbares Material angeordnet sein, mittels welchem die Elemente 42, 43 insbesondere miteinander verbunden sind.

Das erste Element 42 und das zweite Element 43 sind insbesondere mit einem metallischen Werkstoff ausgeführt. Wird ein Abstand zwischen dem ersten Element 42 und dem zweiten Element 43 beispielsweise mittels eines von einem Nutzer betätigbaren Betätigungselements, das vorzugsweise in dem Haltebereich 22 und/oder dem Griffbereich 27 der Werkzeugmaschine 1 angeordnet ist, verändert, wird entsprechend eine aktuelle elektrische Ladung des Sensorelements 40 verändert. Dies ist dadurch bedingt, dass das zweite Element 43 gemeinsam mit dem ersten Element 42 einen Kondensator darstellt, dessen elektrische Ladung in Abhängigkeit von einem Abstand der Elemente 42, 43 zueinander variiert und mit abnehmendem Abstand zunimmt. Das Funktionsprinzip entspricht hierbei dem oben näher beschriebenen Vorgehen zur Ermittlung einer Ladungsänderung.

Analog zu den obigen Ausführungen ist ein definierter Schwellwert für die elektrische Ladung vorgesehen, dessen Überschreitung als anwenderseitige Betätigung des Sensorelements 40 interpretierbar ist. Mittels des Sensorelements 40 ist in Abhängigkeit der Wahl der Federkonstante der Federeinrichtung 45 bzw. der Wahl des elastisch verformbaren Materials auf einfache Weise eine Mindestkraft vorgebbar, mit der das mit dem zweiten Element 43 verbundene Betätigungselement betätigbar ist, um den definierten Schwellwert zu überschreiten und den Leistungsschalter 21 in oben beschriebener Weise in den aktiven Zustand zu überführen. Ein unbeabsichtigtes Überführen des Leistungsschalters 21 von dem inaktiven Zustand in den aktiven Zustand kann hierdurch sicher verhindert werden.

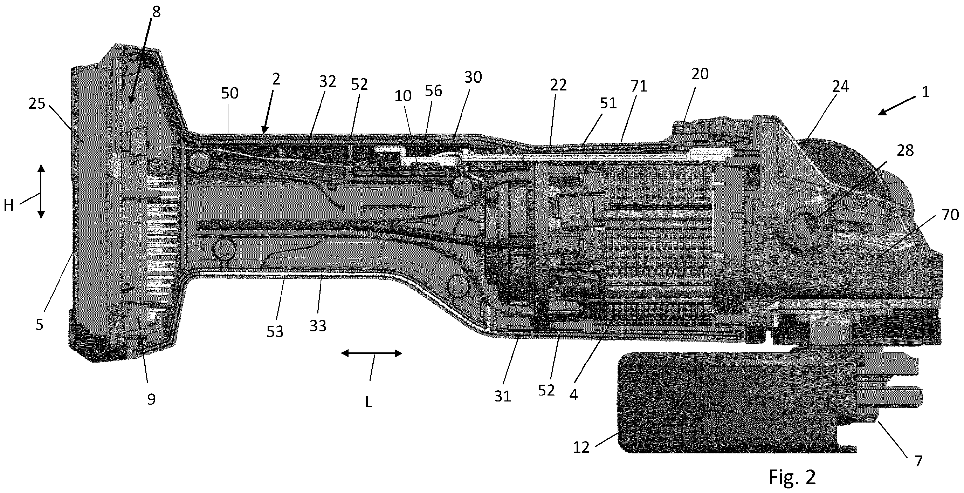

Wie insbesondere Fig. 2 bis Fig. 5 zu entnehmen ist, weist die Werkzeugmaschine 1 einen in Längsrichtung L der Werkzeugmaschine 1 verlaufenden Hauptkanal 50 auf, der sich im Wesentlichen von einem Fußbereich 51, in dem der Akkumulator 5 und die Hauptsteuerungselektronik 9 befindet, bis zu dem Kopfbereich 24 der Werkzeugmaschine 1 erstreckt. Durch den Hauptkanal 50 wird Kühlluft geführt, die durch Lüftungsöffnungen in dem Fußbereich 51 der Werkzeugmaschine 1 mittels eines Lüfters eingesaugt und in Längsrichtung L durch den Hauptkanal 50 insbesondere zur Kühlung des Elektromotors 5 geführt wird.

Die jeweiligen Sensorelemente 30, 31, 32, 33, 34, 35 sind hier nahezu vollständig jeweils in einem von dem Hauptkanal 50 getrennten Bereich angeordnet. Vorzugsweise sind die Bereiche als separate Kanäle 51, 52, 53,54 ausgeführt, wobei jedem Sensorelement 30, 31, 32, 33 ein separater Kanal 51, 52, 53, 54 zugeordnet ist. In jedem Kanal 51, 52, 53, 54 ist hier jeweils ein einziges Sensorelement 30, 31, 32, 33 angeordnet, wobei es auch vorgesehen sein kann, dass in einem Kanal zumindest bereichsweise zwei oder mehr Sensorelemente angeordnet sind. Neben den Sensorelementen 30, 31, 32, 33 kann auch den Sensorelementen 34, 35 in vergleichbarer Weise ein separater Kanal zugeordnet sein.

Jeder Kanal 51, 52, 53, 54 erstreckt sich hier im Wesentlichen ausgehend von dem Steuerungselement 10 bis zu einem von dem Steuerungselement 10 entfernten Endbereich des jeweiligen Sensorelements 30, 31, 32, 33, wobei die Kanäle 51, 52, 53, 54 vorliegend im Wesentlichen vollständig von dem Hauptkanal 50 getrennt bzw. separiert sind.

Durch die Kanäle 51, 52, 53, 54 sind die Sensorelemente 30, 31, 32, 33 derart von dem Hauptkanal 50 getrennt, dass die Sensorelemente 30, 31, 32, 33 sicher vor im Hauptkanal 50 vorliegenden Störeinflüssen beispielsweise in Form von Feuchtigkeit und/oder Schmutz, beispielsweise leitfähiger Schleifstaub, geschützt sind. Derartige Störeinflüsse könnten eine Funktionsfähigkeit der Sensorelemente 30, 31, 32, 33 stören und gegebenenfalls zu einer Fehldetektion führen. Dies ist durch die von dem Hauptkanal 50 getrennte Anordnung der Sensorelementen 30, 31, 32, 33 in den jeweiligen Kanälen 51, 52, 53, 54 sicher verhindert.

Neben den Sensorelementen 30, 31, 32, 33 ist vorliegend auch das Steuerungselement 10 von dem Hauptkanal 50 getrennt und in einem separaten Bereich bzw. einer Kammer 56 angeordnet. Somit ist das Steuerungselement 10 vergleichbar zu den Sensorelementen 30, 31, 32, 33 vor im Hauptkanal 50 vorliegenden Bedingungen geschützt, die eine Funktionalität des Steuerungselements 10 stören könnten.

Durch diese Maßnahmen ist die Gefahr einer Fehldetektion eines oder mehrere der Sensorelemente 30, 31, 32, 33 durch in dem Hauptkanal 50 vorliegende Bedingungen auf einfache Weise stark reduziert.

Um die Kanäle 51, 52, 53, 54 auf konstruktiv einfache Weise auszubilden, ist das Gehäuse 2 vorliegend derart zweiteilig ausgeführt, dass vorzugsweise jeder Kanal 51, 52, 53, 54 und die Kammer 56 durch wenigstens zwei Teile des Gehäuses 2 gemeinsam gebildet ist. Hierdurch ist eine Montage der Werkzeugmaschine 1 einfach durchführbar.

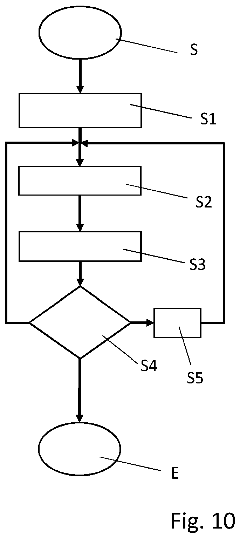

In Fig. 10 ist beispielhaft eine Ausführungsform eines Verfahrens zum Betätigen der Werkzeugmaschine 1 gezeigt.

Das Verfahren beginnt mit dem Start S insbesondere bei einer anwenderseitigen Betätigung beispielsweise des Schalters 20. In einem ersten Schritt S1 wird der Leistungsschalter 21 in den inaktiven Zustand eingestellt. Vorzugsweise ist der Leistungsschalter 21 voreingestellt im inaktiven Zustand.

In einem zweiten Schritt S2 werden die elektrischen Ladungen der jeweiligen Sensorelemente 30, 31, 32, 33, 34, 35, 40 ermittelt und diese im Schritt S3 mit den jeweils zugeordneten definierten Schwellwerten verglichen. Im Schritt S4 wird geprüft, ob eine vordefinierte Bedingung zwischen den ermittelten elektrischen Ladungen und den jeweiligen Schwellwerten der Sensorelemente 30, 31, 32, 33, 34, 35, 40, wie oben beispielhaft näher beschrieben, vorliegt.

Ist die Abfrage im Schritt S4 negativ und die vordefinierte Bedingung liegt nicht vor, wird der Leistungsschalter 21 im Schritt S5 in den inaktiven Zustand überführt bzw. in den inaktiven Zustand belassen und das Verfahren mit Schritt S2 fortgesetzt.

Ist das Abfrageergebnis in Schritt S4 positiv wird der Leistungsschalter 21 im Schritt S6 in den aktiven Zustand überführt bzw. in dem aktiven Zustand belassen, so dass eine anwenderseitige Betätigung des Schalters 20 zu einer Aktivierung der Antriebseinrichtung 4 führt. Anschließend wird das Verfahren mit Schritt S2 fortgesetzt.

Im Schritt E wird das Verfahren insbesondere dann beendet, wenn keine anwenderseitige Betätigung mehr vorliegt.

## Patentansprüche

1. Verfahren zur Betätigung einer handgeführten Werkzeugmaschine (1) mit einer Antriebseinrichtung (4), mittels der ein mit der Werkzeugmaschine (1) in Wirkverbindung bringbares Werkzeug (3) betätigbar ist, wobei eine Steuerungseinrichtung (8) zur Betätigung der Antriebseinrichtung (4) und wenigstens zwei mit der Steuerungseinrichtung (8) wirkverbundene, kapazitive Sensorelemente (30, 31, 32, 33, 34, 35, 40) vorgesehen sind, wobei das Verfahren durch die folgenden Verfahrensschritte gekennzeichnet ist:
- Ermittlung einer ersten elektrischen Ladung des ersten Sensorelements (30, 31, 32, 33, 34, 35, 40),
- Ermittlung einer zweiten elektrischen Ladung des zweiten Sensorelements (30, 31, 32, 33, 34, 35, 40),
- Vergleichen der ermittelten ersten elektrischen Ladung mit einem definierten ersten Schwellwert;
- Vergleichen der ermittelten zweiten elektrischen Ladung mit einem definierten zweiten Schwellwert;
- Freigabe der Betätigung der Antriebseinrichtung (4) und/oder definierte Ansteuerung der Antriebseinrichtung (4) durch die Steuerungseinrichtung (8), wenn eine vordefinierte Bedingung zwischen der ermittelten ersten elektrischen Ladung des ersten Sensorelements (30, 31, 32, 33, 34, 35, 40) und der ermittelten detektierten zweiten elektrischen Ladung des zweiten Sensorelements (30, 31, 32, 33, 34, 35, 40) vorliegt.

2. Verfahren nach Anspruch 1, **dadurch gekennzeichnet, dass** die Steuerungseinrichtung (8) eine Betätigung der Antriebseinrichtung (4) freigibt, wenn die ermittelte erste elektrische Ladung des ersten Sensorelements (30, 31, 32, 33, 34, 35, 40) größer als der erste definierte Schwellwert und die ermittelte zweite elektrische Ladung des zweiten Sensorelements (30, 31, 32, 33, 34, 35, 40) größer als der zweite definierte Schwellwert ist.

3. Verfahren nach Anspruch 1 oder 2, **dadurch gekennzeichnet, dass** die Steuerungseinrichtung eine Betätigung der Antriebseinrichtung (4) freigibt, wenn die ermittelte elektrische Ladung eines Sensorelements (30, 31, 32, 33, 34, 35, 40) größer als der entsprechende definierte Schwellwert und die ermittelte elektrische Ladung des zweiten Sensorelements (30, 31, 32, 33, 34, 35, 40) kleiner als der entsprechende definierte Schwellwert ist.

4. Verfahren nach einem der vorhergehenden Ansprüche, **dadurch gekennzeichnet, dass** weitere Sensorelemente (30, 31, 32, 33, 34, 35, 40) vorgesehen sind, wobei die elektrische Ladung des jeweiligen Sensorelements (30, 31, 32, 33, 34, 35, 40) ermittelt wird und die ermittelte elektrische Ladung mit einem, dem jeweiligen Sensorelement (30, 31, 32, 33, 34, 35, 40) zugeordneten definierten Schwellwert verglichen wird, wobei die Steuerungseinrichtung (8) eine Betätigung der Antriebseinrichtung (4) freigibt und/oder eine definierte Ansteuerung der Antriebseinrichtung (4) vornimmt, wenn eine vordefinierte Bedingung zwischen den ermittelten Ladungen der jeweiligen Sensorelemente (30, 31, 32, 33, 34, 35, 40) vorliegt.

5. Verfahren nach einem der vorhergehenden Ansprüche, **dadurch gekennzeichnet, dass** die Ermittlung der elektrischen Ladung eines Sensorelements (30, 31, 32, 33, 34, 35, 40) folgende Schritte umfasst:
- Aufladung des jeweiligen Sensorelements (30, 31, 32, 33, 34, 35, 40)
- Entladung des jeweiligen Sensorelements (30, 31, 32, 33, 34, 35, 40) und Ermittlung einer elektrischen Ladung des jeweiligen Sensorelements (30, 31, 32, 33, 34, 35, 40) mittels der Steuerungseinrichtung (8).

6. Handgeführte Werkzeugmaschine zur Durchführung eines Verfahrens nach einem der Ansprüche 1 bis 5 mit einer Antriebseinrichtung (4), mittels der ein mit der Werkzeugmaschine (1) in Wirkverbindung bringbares Werkzeug (3) betätigbar ist, wobei eine Steuerungseinrichtung (8) zur Betätigung der Antriebseinrichtung (4) vorgesehen ist, wobei wenigstens zwei mit der Steuerungseinrichtung (8) wirkverbundene Sensorelemente (30, 31, 32, 33, 34, 35, 40) vorgesehen sind.

7. Handgeführte Werkzeugmaschine nach Anspruch 6, **dadurch gekennzeichnet, dass** ein Sensorelement (30, 31, 32, 33, 34, 35, 40) zumindest bereichsweise in einem Griffbereich 22, 27) der Werkzeugmaschine (1) angeordnet ist.

8. Handgeführte Werkzeugmaschine nach einem der Ansprüche 6 oder 7, **dadurch gekennzeichnet, dass** ein Sensorelement (30, 31, 32, 33, 34, 35, 40) zumindest bereichsweise in einem Gefahrenbereich der Werkzeugmaschine (1) angeordnet ist.

9. Handgeführte Werkzeugmaschine nach einem der Ansprüche 6 bis 8, **dadurch gekennzeichnet, dass** die Steuerungseinrichtung (8) ein mit der Steuerungseinrichtung (8) wirkverbundenes Steuerungselement (10) aufweist, das mit den Sensorelementen (30, 31, 32, 33, 34, 35, 40) wirkverbunden ist.

10. Handgeführte Werkzeugmaschine nach Anspruch 9, **dadurch gekennzeichnet, dass** das Steuerungselement (10) eine Kontrolleinheit und einen Signalerzeuger aufweist.

11. Handgeführte Werkzeugmaschine nach einem der Ansprüche 6 bis 10, **dadurch gekennzeichnet, dass** ein mit der Steuerungseinrichtung (8) wirkverbundener Leistungsschalter (21) vorgesehen ist, wobei die Steuerungseinrichtung (8) zur Aktivierung des anwenderseitig betätigbaren Leistungsschalters (21) ausgeführt ist.
